# EUROPÄISCHE PATENTSCHRIFT

(11) **EP 1 993 212 B1**
(45) Veröffentlichungstag und Bekanntmachung des Hinweises auf die Patenterteilung: **14.07.2010**
(21) Anmeldenummer: 08008875.0
(22) Anmeldetag: 13.05.2008
(51) Int. Cl.: H04B 1/40, H03M 1/12

(54) **Wandlervorrichtung**
Converter
Convertisseur

(30) Priorität: 15.05.2007 DE 102007022998
(43) Veröffentlichungstag der Anmeldung: 19.11.2008
(73) Patentinhaber: Atmel Automotive GmbH, 74072 Heilbronn (DE)
(72) Erfinder: Samid, Lourans, 74072 Heilbronn (DE); Dvorszky, Robert, 74074 Heilbronn (DE); Blatz, Werner, 74211 Leingarten (DE); Schwarzmüller, Marco, 74080 Heilbronn (DE); Großkinsky, Ulrich, 74861 Neudenau (DE)
(74) Vertreter: Koch Müller Patentanwaltsgesellschaft mbH

(56) Entgegenhaltungen:
- US-A- 5 327 132
- US-A- 5 825 240
- US-A1- 2004 057 534
- US-A1- 2004 201 508

## Beschreibung

Die vorliegende Erfindung betrifft das Gebiet der Analog/Digital-Wandlung.

Aus der US 5,327,132 ist ein Audiosystem für eine analoge Audioquelle bekannt. Ein Audiosignal ist ein Wechselspannungssignal mit einem typischen Frequenzgang von 20 Hz bis 20 KHz. In herkömmlichen Analog/Digital-Wandlern werden zur Signalverstärkung oft Verstärker eingesetzt, beispielsweise geeignet beschaltete Operationsverstärker. Oft wird ein Gleichspannungs-Messsignal, wie z.B. ein Temperatursignal als digitales Signal benötigt, das zwecks Erfassung oder Weiterverarbeitung in ein digitales Signal gewandelt werden soll.

Aus der US 5,825,240 ist eine Transmissionsleitungstechnologie für resonantes Tunneln bekannt. Hingegen ist aus der US 2004/0057534 A1 ein Digitalempfänger für ein komplexes Zwischenfrequenzsignal bekannt. Aus der US 2004/0201508 A1 sind wiederum ein Verfahren zur Einstellung einer Bandpasses eines AnalogDigital-Umsetzers und eine zugerhörige Architektur bekannt.

Es ist eine Aufgabe der Erfindung ein möglichst verbessertes Wandlungskonzept zu schaffen.

Diese Aufgabe wird durch die Merkmale der unabhängigen Ansprüche gelöst. Vorteilhafte Weiterbildungen sind Gegenstand von abhängigen Ansprüchen und in der Beschreibung enthalten.

Es ist eine Wandlervorrichtung zum Wandeln eines analogen Signals, vorzugsweise eines Gleichspannungs-Signals, in ein digitales Signal vorgesehen.

Die Wandlervorrichtung weist eine Oszillatorvorrichtung auf, die vorzugsweise zur Ausgabe eines ersten Oszillatorsignals und eines zweiten Oszillatorsignals ausgebildet ist. Bevorzugt ist die Oszillatorvorrichtung ausgebildet das erste Oszillatorsignal und das zweite Oszillatorsignal zueinander phasenstarr und mit gleicher Frequenz aus einem Referenzsignal zu erzeugen. Das Referenzsignal ist dabei nicht das erste oder zweite Oszillatorsignal, sondern das Referenzsignal ist vom ersten und zweiten Oszillatorsignal verschieden. Das Referenzsignal ist vorzugsweise von einer Referenzeinrichtung, wie beispielsweise einem Schwingquarz, erzeugbar.

Die Wandlervorrichtung weist einen analogen Frequenzumsetzer zum Umsetzen des analogen (Gleichspannungs-)Signals auf. Der analoge Frequenzumsetzer ist vorzugsweise mit der Oszillatorvorrichtung verbunden. Der Frequenzumsetzer ist ausgebildet zum Umsetzen des analogen (Gleichspannungs-)Signals in einen ersten Spektralbereich mit einer ersten Mittenfrequenz, um ein umgesetztes Signal zu erhalten. Vorzugsweise erfolgt das Umsetzen mittels des ersten Oszillatorsignals. Der analoge Frequenzumsetzer kann beispielsweise ein analoger Mischer sein, der auch komplexwertig sein kann.

Die Wandlervorrichtung weist einen Analog/Digital-Wandler zum Wandeln des umgesetzten Signals in ein umgesetztes digitales Signal auf. Der Analog/Digital-Wandler kann ein herkömmlicher Wandler sein, z.B. ein Sigma-Delta-Wandler.

Die Wandlervorrichtung weist einen digitalen Frequenzumsetzer auf zum Umsetzen des umgesetzten digitalen Signals in einen zweiten Spektralbereich mit einer zweiten Mittenfrequenz, um das digitale Signal zu erhalten. Bevorzugt ist der digitale Frequenzumsetzer mit der Oszillatorvorrichtung verbundenen um die Umsetzung mittels des zweiten Oszillatorsignals zu bewirken. Der digitale Frequenzumsetzer kann beispielsweise ein digitaler Mischer sein, der dem Analog/Digital-Wandler nachgeschaltet ist und der komplexwertig sein kann.

Ein anderer Aspekt der Erfindung ist ein Verfahren zum Wandeln eines analogen Signals, vorzugsweise eines Gleichspannungs-Signals, in ein digitales Signal.

In dem Verfahren werden mittels einer Oszillatorvorrichtung ein erstes Oszillatorsignal und ein zweites Oszillatorsignal aus einem vom ersten und zweiten Oszillatorsignal verschiedenen Referenzsignal erzeugt. Das erste Oszillatorsignal und das zweite Oszillatorsignal sind zueinander phasenstarr und weisen eine gleiche Frequenz auf. Vorzugsweise sind die Phasen beider Signale identisch.

In dem Verfahren wird das analoge Gleichspannungs-Signals mittels eines mit der Oszillatorvorrichtung verbundenen analogen Frequenzumsetzers in Abhängigkeit vom ersten Oszillatorsignal in einen ersten Spektralbereich mit einer ersten Mittenfrequenz umgesetzt, um ein umgesetztes Signal zu erhalten.

Das umgesetzte Signal wird mittels eines Analog/Digital-Wandlers in ein umgesetztes digitales Signal gewandelt.

Das umgesetzte digitale Signal wird mittels eines mit der Oszillatorvorrichtung verbundenen digitalen Frequenzumsetzers in Abhängigkeit vom zweiten Oszillatorsignal in einen zweiten Spektralbereich mit einer zweiten Mittenfrequenz umgesetzt, um das digitale Signal zu erhalten.

Ein anderer Aspekt der Erfindung ist eine Verwendung einer Oszillatorvorrichtung, eines analogen Frequenzumsetzers eines Analog/Digital-Wandlers und eines digitalen Frequenzumsetzers zum Wandeln eines analogen Signals in ein digitales Signal.

Die Erfindung basiert auf der Erkenntnis, das zu wandelnde Analogsignal vor der Wandlung in einen Frequenzbereich umzusetzen, in dem der Rauscheinfluss geringer ist als in dem Frequenzbereich, den das zu wandelnde Analogsignal belegt.

Die im Folgenden beschriebenen Weiterbildungen beziehen sich sowohl auf die Wandlervorrichtung als auch auf das Verfahren als auch auf die Verwendung.

Gemäß einer bevorzugten Weiterbildung ist vorgesehen, dass das Referenzsignal eine höhere Frequenz als das erste und zweite Oszillatorsignal - insbesondere ein ganzzahliges Vielfaches der Frequenz des ersten und zweiten Oszillatorsignals - aufweist. Vorzugsweise ist ein Frequenzteiler vorgesehen, der das erste und/oder zweite Oszillatorsignal mittels Frequenzteilung erzeugt.

In einer vorteilhaften Weiterbildungsvariante ist vorgesehen, dass Signalwerte des zweiten Oszillatorsignals innerhalb einer Periode des zweiten Oszillatorsignals genähert eine Sinus- oder Kosinusform abbilden. Vorzugsweise weist das erste Oszillatorsignal eine Rechteckform auf und ist beispielsweise durch Teilung aus dem Referenzsignal gebildet.

Vorzugsweise weist die Wandlervorrichtung eine Anzahl von mit dem digitalen Frequenzumsetzer verschalteten digitalen Filtern auf. Die Filter sind eingerichtet und ausgebildet zur Ausbildung einer Filterung eines analogen 1/f-Rauschens des Analog/Digital-Wandlers, beispielsweise eines Verstärkers des Analog/Digital-Wandlers.

Gemäß einer bevorzugten Weiterbildung ist vorgesehen, dass der digitale Frequenzumsetzer einen ersten digitalen Mischer zum Anlegen eines In-Phase-Anteils des zweiten Oszillatorsignals und einen zweiten digitalen Mischer zum Anlegen eines Quadratur-Phase-Anteils des zweiten Oszillatorsignals aufweist. Der analoge Frequenzumsetzer weist einen ersten analogen Mischer zum Anlegen eines ersten Signalanteils des ersten Oszillatorsignals mit gleicher Phasenlage wie der In-Phase-Anteil des zweiten Oszillatorsignals und einen zweiten analogen Mischer zum Anlegen eines zweiten Signalanteils des ersten Oszillatorsignals mit gleicher Phasenlage wie der Quadratur-Phase-Anteil des zweiten Oszillatorsignals auf. Vorteilhafterweise sind Schalter zum Schalten des ersten Signalanteils und/oder des zweiten Signalanteils des ersten Oszillatorsignals auch auf weitere analoge Mischer vorgesehen.

Gemäß einer Ausführungsform ist die zweite Mittenfrequenz gleich der ersten Mittenfrequenz. Gemäß einer weiteren Ausführungsform kann die zweite Mittenfrequenz ein Vielfaches der ersten Mittenfrequenz, beispielsweise das Doppelte der ersten Mittenfrequenz, betragen. In diesem Fall wird das Signal in einen noch höheren Frequenzbereich verschoben, wobei die Basisbandkomponente (Spiegelspektrum) mittels eines Tiefpassfilters erfasst werden kann.

Gemäß einer weiteren Ausführungsform ist das digitale Signal in einem dritten Spektralbereich mit einer dritten Mittenfrequenz angeordnet, beispielsweise im Basisband. Dabei kann die Differenz zwischen der zweiten Mittenfrequenz und der dritten Mittenfrequenz geringer sein als die Differenz zwischen der ersten Mittenfrequenz und der dritten Frequenz. Hierzu kann das umgesetzte digitale Signal beispielsweise wieder in die ursprüngliche Frequenzlage verschoben werden. Gemäß einer Ausführungsform sind die zweite und die dritte Mittenfrequenz gleich und liegen im Basisband z.B. bei der Frequenz null.

Gemäß einer weiteren Ausführungsform ist der digitale Frequenzumsetzer ein beispielsweise komplexer Basisbandmischer, dem ein Tiefpassfilter nachgeschaltet sein kann.

Gemäß einer weiteren Ausführungsform umfasst der Analog/Digital-Wandler einen Verstärker mit einer frequenzabhängigen Rauschcharakteristik, wobei die zweite Mittenfrequenz nicht kleiner als die doppelte Comer-Frequenz (bzw. Cut-Off-Frequenz) der frequenzabhängigen Rauschcharakteristik ist.

Gemäß einer weiteren Ausführungsform ist dem Analog/Digital-Wandler ein Dezimationsfilter nachgeschaltet. Vorzugsweise ist eine Eckfrequenz des Dizimationsfilters durch eine Steuereinrichtung einstellbar. Der digitale Frequenzumsetzer erfüllt vorzugsweise zwei Funktionen: zum einen verschiebt er das umgesetzte digitale Signal beispielsweise in die ursprüngliche Frequenzlage zurück und zum anderen dient er zur Frequenzumsetzung für die Abtastratenumsetzung.

Gemäß einer weiteren Ausführungsform ist dem Analog/Digital-Wandler eine Dezimationsfiltereinrichtung nachgeschaltet, die den digitalen Frequenzumsetzer als integralen Bestandteil aufweist. In diesem Fall kann das erfindungsgemäße Konzept besonders günstig realisiert werden.

Gemäß einer weiteren Ausführungsform umfasst die Wandlervorrichtung einen Signalgenerator zum Erzeugen des analogen Signals. Das analoge Signal ist bevorzugt ein Gleichspannungs-Signal. Das analoge Signal kann z.B. ein Temperatursignal sein, dessen Spannungswert proportional zu einer Temperatur ist. Das analoge Signal kann z.B. ein PTAT-Signal sein (PTAT: Proportional to Absolute Temperature). Der Signalgenerator kann ferner ausgebildet sein, um die Temperatur zu messen und um ein Temperatursignal auszugeben, das auf die gemessene Temperatur hinweist.

Gemäß einer weiteren Ausführungsform umfasst die Wandlervorrichtung ferner einen Schalter zum Schalten eines Ausgangs des analogen Frequenzumsetzers auf einen Eingang des Analog/Digital-Wandlers. Der Schalter kann beispielsweise ausgebildet sein, in einer ersten Schalterstellung den Ausgang des analogen Frequenzumsetzers auf den Eingang des Analog/Digital-Wandlers und in einer zweiten Schalterstellung einen weiteren Anschluss auf den Eingang des Analog/Digital-Wandlers zu schalten, wobei an den weiteren Anschluss - insbesondere heraufgemischtes - Sendesignal oder ein - insbesondere heruntergemischtes - Empfangssignal anlegbar ist. So wird in der ersten Schalterstellung beispielsweise nur das Ausgangssignal des Signalgenerators mittels des analogen Frequenzumsetzers umgesetzt, wobei in der zweiten Schalterstellung z.B. das Empfangssignal direkt dem Analog/Digital-Wandler zugeführt wird.

Gemäß einer bevorzugten Weiterbildung ist vorgesehen, dass die Wandlervorrichtung eine Anzahl von mit dem digitalen Frequenzumsetzer verschalteten digitalen Filtern aufweist. Weiterhin weist die Wandlervorrichtung eine Steuereinrichtung auf, die zur von der ersten Schalterstellung beziehungsweise der zweiten Schalterstellung abhängigen Einstellung von Eckfrequenzen des jeweiligen Filters eingerichtet ist.

Gemäß einer weiteren Ausführungsform ist dem digitalen Frequenzumsetzer ein Tiefpassfilter nachgeschaltet, um beispielsweise sein Spiegelspektrum-Basisbandsignal zu erfassen, um das digitale Signal zu erhalten.

Gemäß einem weiteren Aspekt schafft die Erfindung eine Empfangsvorrichtung mit der zuvor erläuterten Wandlervorrichtung. Dabei ist ein Empfangssignal an einen Eingang des Analog/Digftal-Wandlers anlegbar.

Gemäß einem weiteren Aspekt schafft die Erfindung ein Empfangsverfahren mit den Schritten des erfindungsgemäßen Verfahrens zum Wandeln, wobei zusätzlich ein Empfangssignal entweder in den ersten Spektralbereich umgesetzt wird und das umgesetzte Signal bildet oder direkt gewandelt wird, um das digitale Signal zu erhalten. Weitere Verfahrensschritte ergeben sich direkt aus der Funktionalität der Empfangsvorrichtung.

Gemäß einem weiteren Aspekt schafft die Erfindung ein Programm zum Durchführen zumindest eines des zuvor erläuterten Verfahrens, wenn das Programm auf einer Recheneinheit abläuft.

Gemäß einem weiteren Aspekt schafft die Erfindung eine Datenverarbeitungsvorrichtung, die programmtechnisch eingerichtet ist, um das zuvor erläuterte Programm zum Ausführen der Schritte zumindest eines der zuvor erläuterten Verfahren ablaufen zu lassen.

Ausführungsbeispiele werden Bezug nehmend auf die beiliegenden Zeichnungen beschrieben. Es zeigen:
- Fig. 1: ein schematisches Blockdiagramm einer Wandlervorrichtung;
- Fig. 2: ein schematisches Blockdiagramm einer Wandlervorrichtung;
- Fig. 3: ein schematisches Schaltbild einer Wandlervorrichtung;
- Fig.4: ein schematisches Blockdiagramm einer Kommunikationsvorrichtung;
- Fig.5: ein schematisches Blockdiagramm einer Kommunikationsvorrichtung; und
- Fig. 6: ein schematisches Diagramm mit Oszillatorsignalen.

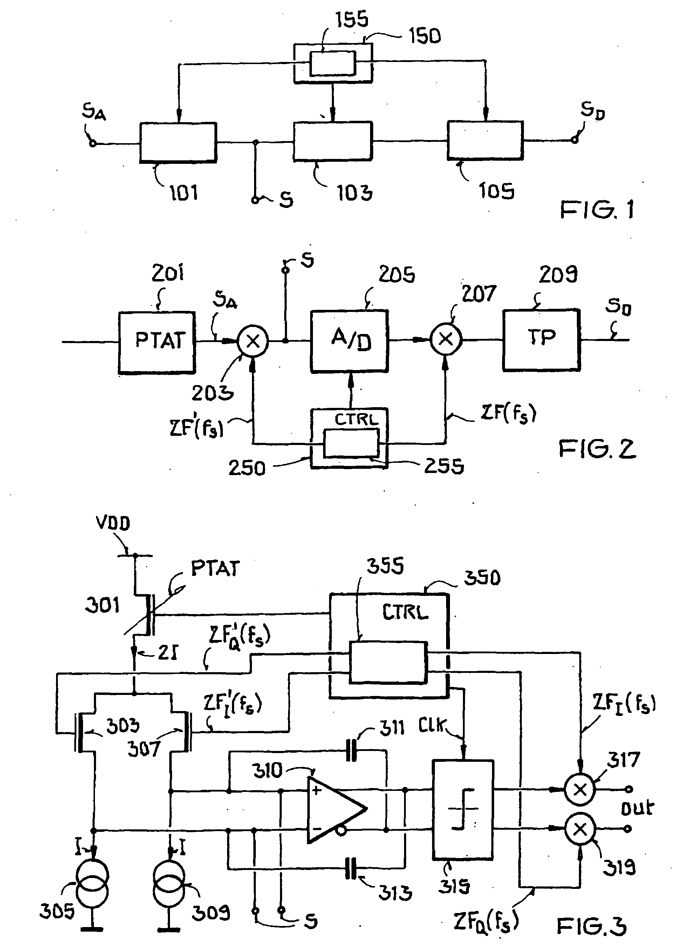

Fig. 1 zeigt eine Wandlervorrichtung zum Wandeln eines analogen Gleichspannungs-Signals S_{A}, das an einen Eingang eines analogen Frequenzumsetzers 101 anlegbar ist, in ein digitales Signal. Die Wandlervorrichtung umfasst einen Analog/Digital-Wandler 103, der dem analogen Frequenzumsetzer 101 nachgeschaltet ist, und einen digitalen Frequenzumsetzer 105, der dem Analog/Digital-Wandler 103 nachgeschaltet ist und ein digitales Signal s_{D} liefert.

Der analoge Frequenzumsetzer 101 (z.B. ein analoger Mischer) verschiebt das analoge Signal im Frequenzbereich um beispielsweise einen Frequenzabstand, der der doppelten Comer-Frequenz eines in dem Analog/Digital-Wandler 103 eingesetzten Verstärkers entspricht. Das umgesetzte Signal liegt daher in einem Frequenzbereich, der beispielsweise durch das 1/f-Rauschen des Verstärkers weniger beeinträchtigt ist als der ursprüngliche Frequenzbereich (0 Hz bis wenige Hz) des analogen Gleichspannungs-Signals. Der Analog/Digital-Wandler 103 wandelt das im Frequenzbereich verschobene Signal in ein umgesetztes digitales Signal und führt dieses dem digitalen Frequenzumsetzer 105 (z.B. digitalem Mischer) zu.

Der digitale Frequenzumsetzer 105 verschiebt das umgesetzte digitale Signal beispielsweise um denselben Frequenzabstand in Richtung von höheren Frequenzen, um einen Spiegelfrequenzanteil bei der ursprünglichen Frequenzlage des analogen Gleichspannungs-Signals s_{A} zu erhalten. Um diese Komponente zu erfassen, kann ein Tiefpassfilter vorgesehen werden, das dem digitalen Frequenzumsetzer 105 nachgeschaltet ist. Alternativ kann der digitale Frequenzumsetzer 105 das umgesetzte digitale Signal wieder in die ursprüngliche Frequenzlage, z.B. in die Basisbandlage, zurück verschieben.

Weiterhin ist eine Steuereinrichtung 150 vorgesehen, die beispielsweise den Analog/Digital-Wandler 103 steuert. Beispielweise ist durch die Steuereinrichtung 150 die Abtastfrequenz des Analog/Digital-Wandlers 103 steuerbar. An den Analog/Digital-Wandler 103 ist wahlweise zum umgesetzten analogen Gleichspannungs-Signal s_{A} ein Empfangssignal s anlegbar, das mittels des Analog/Digital-Wandlers 103 wandelbar ist. Nach einer Analog/Digital-Wandlung wird das Empfangssignal s durch den digitalen Frequenzumsetzer 105 in ein Basisband geschoben und beispielsweise durch einen Demodulator demoduliert.

Im Ausführungsbeispiel der Fig. 1 ist zudem eine Oszillatorvorrichtung 155 vorgesehen, die ein erstes Oszillatorsignal für den analogen Frequenzumsetzer 101 und ein zweites Oszillatorsignal für den digitalen Frequenzumsetzer 105 ausgibt. Beide Oszillatorsignale weisen dieselbe Frequenz und Phase auf. Hingegen ist die Amplitudenform des ersten Oszillatorsignals und des zweiten Oszillatorsignals unterschiedlich.

Fig. 2 zeigt eine Wandlervorrichtung mit einem Signalgenerator 201 (PTAT), dem ein analoger Mischer 203 nachgeschaltet ist. Ein Ausgang des analogen Mischers 203 ist mit einem Eingang eines Analog/Digital-Wandlers 205 (A/D) gekoppelt. Dem Analog/Digital-Wandler 205 ist ein digitaler Mischer 207 nachgeschaltet, dessen Ausgang mit einem Eingang eines Tiefpassfilters 209 (TP) verbunden ist.

Der Signalgenerator 201 erzeugt beispielsweise ein PTAT-Signal, das mittels des analogen Mischers 203 z.B. um eine Frequenz fs umgesetzt wird. Hierzu ist eine mit dem analogen Mischer 203 verbundene Oszillatorvorrichtung 255 vorgesehen, die ein erstes Oszillatorsignal ZF'(fs) mit der Frequenz fs aus einem Referenzsignal erzeugt und an den Mischer 203 anlegt. Das umgesetzte Signal wird mittels des Analog-Digital-Wandlers 205 analog/digital gewandelt und mittels des digitalen Mischers 207 erneut um dieselbe Frequenz fs im Frequenzbereich verschoben.

Hierzu ist die Oszillatorvorrichtung 255 mit dem digitalen Mischer 207 verbunden und gibt ein zweites Oszillatorsignal ZF(fs) mit der Frequenz fs an den digitalen Mischer 207 aus. Die Oszillatorvorrichtung 255 ist ausgebildet das erste Oszillatorsignal ZF'(fs) und das zweite Oszillatorsignal ZF(fs) zueinander phasenstarr auszugeben. Das Tiefpassfilter 209 ist optional vorgesehen, um die Basisbandkomponente des Ausgangssignals des digitalen Mischers 207 zu erfassen. Weiterhin ist eine Steuereinrichtung 250 (CTRL) zur Steuerung des Analog/Digital-Wandlers 205 und zumindest einer Eckfrequenz des Filters 209 vorgesehen.

Das Ausführungsbeispiel der Fig. 2 weist den Vorteil auf, dass der Rauscheinfluss durch eine äußere Beschaltung des Analog/Digital-Wandlers 205 reduziert werden kann, ohne dass die Wandlerstruktur signifikant geändert werden müsste. Das Ausführungsbeispiel der Fig. 2 kann besonders bevorzugt einen Sigma-Delta-Wandler verwenden.

Fig. 3 zeigt ein Schaltbild einer Wandlervorrichtung mit einem Transistor 301, dem eine analoge Mischerschaltung umfassend einen ersten Transistor 303, eine dem ersten Transistor 303 nachgeschaltete Stromquelle 305, einen zweiten Transistor 307 und eine dem zweiten Transistor 307 nachgeschaltete zweite Stromquelle 309 nachgeschaltet ist. Beide Transistoren 303, 307 können z.B. Feldeffekttransistoren unterschiedlichen Leitungstyps sein. Der Transistor 307 ist, wie in Fig. 3 eingezeichnet, mit einem ersten Eingang eines Operationsverstärkers 310 verbunden.

Der Transistor 303 ist mit einem zweiten Eingang des Operationsverstärkers 310 verbunden. Ein erster Ausgang des Operationsverstärkers 310 ist über eine Kapazität 311 mit dessen ersten Eingang verbunden. Ein zweiter Ausgang des Operationsverstärkers 310 ist über eine Kapazität 313 mit dessen zweiten Eingang verbunden. Beide Ausgänge des Operationsverstärkers 310 sind mit Eingängen eines Detektors 315 verbunden, der beispielsweise ein Schwellwertdetektor sein kann. Der Detektor 315 umfasst zwei Ausgänge, die jeweils mit einem digitalen Mischer 317 bzw. 319 verbunden sind, die das digitale Ausgangssignal s_{D} liefern.

An den ersten Transistor 301 ist beispielsweise die Spannung Vdd anlegbar. Der Transistor ist durch die Steuereinrichtung 350 steuerbar und liefert in Abgängigkeit von einem an dessen Steuereingang anlegbaren Steuersignal z.B. ein PTAT-Signal der Stromstärke 2I, wobei die Stromquellen jeweils einen Strom I liefern. Es ist eine Oszillatorvorrichtung 355 vorgesehen, die ein erstes Oszillatorsignal ZF'_{Q}(fs), ZF'_{I}(fs) und eine zweites Oszillatorsignal ZF_{Q}(fs), ZF_{I}(fs) ausgibt. Das zweite Oszillatorsignal weist dabei einen In-Phase-Anteil ZF_{I}(fs) und einen Quadratur-Phase-Anteil ZF_{Q}(fs) auf, die um 90° phasenverschoben sind.

Ein erster Anteil ZF_{I}'(fs) des ersten Oszillatorsignals weist die gleiche Phase wie der In-Phase-Anteil ZF_{I}(fs) des zweiten Oszillatorsignals auf und ist zu diesem phasenstarr. Ein zweiter Anteil ZF_{Q}'(fs) des ersten Oszillatorsignals weist die gleiche Phase wie der In-Phase-Anteil ZF_{Q}(fs) des zweiten Oszillatorsignals auf und ist zu diesem phasenstarr. An die Steuereingänge der Transistoren 303 und 307, die zur analogen Frequenzumsetzung vorgesehen sind, sind die Anteile ZF'_{Q}(fs), ZF'_{I}(fs) des ersten Oszillatorsignals anlegbar, die beispielsweise eine Zwischenfrequenz fs repräsentieren bzw. diese in Form einer Schwingung abbilden.

Das umgesetzte Signal wird mittels des Verstärkers 310 und des mittels des Taktsignals clk durch die Steuerungseinrichtung 350 steuerbaren Detektors 315 analog/digital gewandelt und durch die digitalen Mischer 317, 319, in einen weiteren Spektralbereich umgesetzt. An die digitalen Mischer 317 und 319 sind der In-Phase-Anteil ZF_{I}(fs) und der Quadratur-Phase-Anteil ZF_{Q}(fs) des zweiten Oszillatorsignals anlegbar, die die beispielsweise die vorstehend erwähnte Zwischenfrequenz fs repräsentieren bzw. diese in Form einer Schwingung abbilden.

Erfindungsgemäß wird beispielsweise ein eine Temperatur repräsentierendes Temperatursignal mit der Frequenz fs moduliert, analog/digital gewandelt und digital wieder auf Gleichspannungswerte (DC) verschoben. Die Analog/Digital-Wandlung kann daher für Daten, z.B. RKE (Remote Keyless Entry), sowie für einen Sensor /Temperatursensor, Drucksensor) verwendet werden. Im Ausführungsbeispiel der Fig. 3 ist es daher nicht mehr notwendig, dass analoge Komponenten schalten müssen. Das führt zu einer Reduktion des Leistungsverbrauchs, weil keine analogen Filter nach dem Mischer verwendet werden, sowie der Reduktion der für den Analog/Digial-Wandler 315 benötigten (Chip-)Fläche, weil weitere analoge Komponenten und Filter nicht benötigt werden.

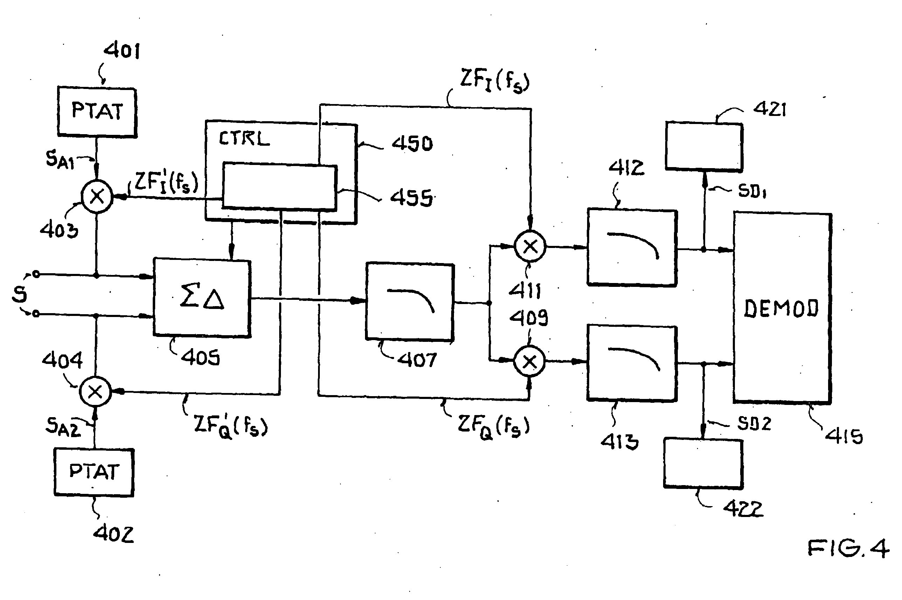

Fig. 4 zeigt eine Kommunikationsvorrichtung mit einem Signalgenerator 401 (z.B. PTAT-Signalgenerator) zum Erzeugen eines analogen Gleichspannungs-Signals s_{A1}, dem ein analoger Frequenzumsetzer 403, z.B. ein analoger Mischer, nachgeschaltet ist. Der Mischerausgang ist mit einem ersten Eingang eines Analog/Digital-Wandlers 405, z.B. eines Sigma-Delta-Wandlers, verbunden. Der Analog/Digital-Wandler 405 hat ferner einen zweiten Eingang. An beide Eingänge ist zudem ein Empfangssignal s anlegbar. Ein Ausgang des Analog/Digftal-Wandlers 405 ist mit einem Filter 407, z.B. einem mittels der Steuereinrichtung 450 steuerbaren Dezimationsfilter oder einem Tiefpassfilter, verbunden. Einem ersten digitalen Frequenzumsetzer 411 ist ein Filter 412, z.B. ein Tiefpassfilter, nachgeschaltet. Einem zweiten digitalen Umsetzer 409 ist ein Filter 413, z.B. ein Tiefpassfilter, nachgeschaltet. Die Ausgänge der Filter 412 und 413 sind z.B. mit einem Demodulator 415 (DEMOD) zur Demodulation des Empfangssignals s verbunden.

Der zweite Eingang des Analog/Digital-Wandlers 405 ist zudem mit einem Ausgang eines weiteren analogen Mischers 404 verbunden. Der weitere analoge Mischer 404 ist mit einem weiteren Signalgenerator 402 verbunden, der ein weiteres analoges Gleichspannungssignal S_{A2} erzeugt. Die Mischer 403, 404 werden von der Oszillatorvorrichtung 455 mit einem ersten Oszillatorsignal ZF'_{Q}(fs), ZF'_{I}(fs) beaufschlagt. Hingegen werden die Mischer 411 und 409 von der Oszillatorvorrichtung 455 mit einem zweiten Oszillatorsignal ZF_{Q}(fs), ZF_{I}(fs) beaufschlagt. Durch jeweiligen Phasenunterschied der Anteile von 90° können beide analogen Gleichspannungs-Signale s_{A1} und s_{A2} gleichzeitig analog/digital gewandelt und nach der Tiefpassfilterung durch die Tiefpässe 412 und 413 parallel durch die Auswerteeinrichtungen 421 und 422 gleichzeitig parallel ausgewertet werden. Hierbei ist lediglich erforderlich, dass die Oszillatorsignale ZF_{Q}(fs), ZF_{I}(fs) und ZF'_{Q}(fs), ZF'ᵢ(fs) der Oszillatorvorrichtung 455 gleicher Frequenz fs und phasenstarr zueinander sind.

Das Ausführungsbeispiel der Fig. 4 kann dabei weitergebildet werden, indem über die analogen Mischer 403 und 404 weitere analoge Frequenzumsetzer (nicht dargestellt) vorgesehen sind. Weiterhin ist ein Multiplexer (nicht dargestellt) vorgesehen, der durch die Steuereinrichtung 450 steuerbar ist. Der Multiplexer ist zum Schalten des ersten Oszillatorsignals ZF'_{Q}(fs), ZF'_{I}(fs) auf die Mischer 403, 404 und die weiteren analogen Frequenzumsetzer ausgebildet und verschaltet. So können eine größere Anzahl von Sensorsignalen durch eine Auswahl mittels des Multiplexers analog/digital wahlweise gewandelt werden.

Der analoge Frequenzumsetzer 403 setzt das Ausgangssignal des Signalgenerators 401 z.B. auf eine Zwischenfrequenz um, wobei das umgesetzte Signal nach einer Filterung dezimiert wird. Die digitalen Mischer 411, 409 werden derart angesteuert, dass die an den Mischern anliegenden Signale z.B. wieder ins Basisband umgesetzt werden.

An den beiden Eingänge des Analog/Digital-Wandlers 405 ist beispielsweise ein Empfangssignal s anlegbar, das von einer Empfangsschaltung empfangbar ist. So kann der Analog/Digital-Wandler 405 z.B. das Empfangssignal in der ursprünglichen Frequenzlage und/oder das Ausgangssignal des Signalgenerators 401, der ein Messsignal liefern kann, in der umgesetzten Frequenzlage wandeln. Die Ansteuerung der digitalen Mischer 411 und 409 kann dabei für das Empfangssignal und für das Ausgangssignal des Signalgenerators 401 jeweils unterschiedlich oder gleich sein.

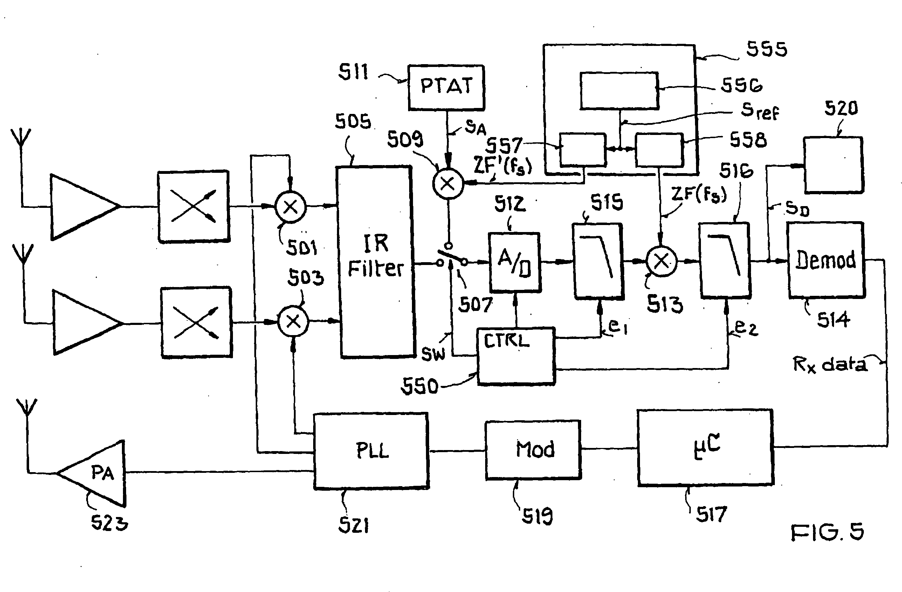

Fig. 5 zeigt ein schematisches Blockdiagramm einer Kommunikationsvorrichtung mit einem ersten analogen Frequenzumsetzer 501 und einem zweiten analogen Frequenzumsetzer 503 einer Empfangsschaltung. Die Ausgänge der analogen Frequenzumsetzer 501 und 503 sind mit einem Filter 505, z.B. einem IF (Intermediate Frequency) Filter verbunden. Ein Ausgang des Filters 505 ist mit einem ersten Anschluss eines Schalters 507, beispielsweise eines Transistorschalters oder Multiplexers, verbunden. Der Schalter weist ferner einen zweiten Anschluss auf, mit dem ein Ausgang eines dritten analogen Frequenzumsetzers 509 verbunden ist. Ein Eingang des dritten analogen Frequenzumsetzers 509 ist mit einem Ausgang eines Signalgenerators 511, z.B. eines PTAT- oder eines Druckmesssignalgenerators, verbunden.

Ein weiterer Anschluss des Schalters 507 ist über einen Analog/Digital-Wandler 512 (A/D) mit einem Dezimationsfilter 515 verbunden. Ein Ausgang des Dezimationsfilters 513 ist z.B. über einen digitalen Mischer 513 und über einen Tiefpassfilter 516 und über einen Demodulator 514 (Demod) mit einem Eingang eines Mikrocontrollers 517 (µC) verbunden, dessen Ausgang mit einem Modulator 519 (Mod) verbunden ist. Ein Ausgang des Modulators 519 ist mit einer PLL-Schaltung 521 (Phase-Locked Loop) verbunden. Die PLL-Schaltung 521 weist Ausgänge auf, die mit Steuereingängen der analogen Frequenzumsetzer 501 und 503 der Empfangsschaltung verbunden sind. Ein weiterer Ausgang der PLL-Schaltung 521 ist über einen Leistungsverstärker 523 (PA: Power Amplifier) mit z.B. einer Antenne verbunden.

Die über die in Fig. 5 dargestellten Empfangsantennen empfangbaren Empfangssignale werden nach einer Verstärkung durch die analogen Mischer 501 und 503 heruntergemischt und dem Filter 505 zugeleitet. Befindet sich der Schalter 507 in einer ersten Stellung, so wird das Filterausgangssignal analog/digital gewandelt und dem Dezimationsfilter 515 zugeleitet, wobei ein Ausgangssignal des Dezimationsfilters 515 wie in Fig. 5 dargestellt weiterverarbeitet wird.

Befindet sich der Schalter 507 in einer zweiten Schalterstellung, so wird dem Dezimationsfilter 515 ein durch den analogen Frequenzumsetzer 509 umgesetztes Gleichspannungs-Ausgangssignal s_{A} des Signalgenerators 511 zugeführt, das nach der Analog/Digital-Wandlung dem Dezimationsfilter 515 zugeleitet wird. Der des Dezimationsfilters 515 wird dabei durch z.B. eine Steuereinrichtung 550 mittels des Steuersignals e₁ angesteuert um die Eckfrequenzen des Dezimationsfilters 515 einzustellen. Hierdurch kann für die zweite Schalterstellung des Schalters 507 für das analoge Gleichspannungs-Signal s_{A} des Signalgenerators 511 die Bandbreite der durch die Filter 515 und 516 und den digitalen Mischer 513 erzeugten Bandpasswirkung besonders schmal gezogen werden.

Der digitale Mischer 513 setzt das Eingangssignal dabei derart um, dass, nach einer optionalen Tiefpassfilterung durch den Filter 513, ein Ausgangssignal des Filters 513 das digitalisierte Ausgangssignal s_{D} des Signalgenerators 511 repräsentiert. Dadurch werden z.B. die Messergebnisse durch das Rauschen des in dem Analog/Digital-Wandler 512 vorgesehenen Verstärkers nicht beeinträchtigt. Das digitale Signal s_{D} wird vom Empfangspfad abgezweigt und in der Auswerteeinrichtung 520 ausgewertet, die, da lediglich Gleichanteile auszuwerten sind, besonders einfach ausgebildet werden kann.

Zur Steuerung des Schalters 507 mittels eines Steuersignals sw kann ferner die Steuereinrichtung 550 vorgesehen werden, die den Schalter 507 entweder in die erste oder in die zweite Schalterstellung schaltet und abhängig hiervon die Eckfrequenzen der Filter 515 und 516 einstellt. Weiterhin ist eine Oszillatorvorrichtung 555 vorgesehen, die ein erstes Oszillatorsignat ZF'(fs) an den analogen Mischer 509 und ein zweites Oszillatorsignal ZF(fs) an den digitalen Mischer 513 ausgibt. Damit beide Oszillatorsignale ZF'(fs) und ZF(fs) die gleiche Frequenz fs aufweisen und zueinander phasenstarr sind, weist die Oszillatorvorrichtung 555 eine Referenzeinrichtung 556 oder einen Anschluss für eine Referenzeinrichtung 556 - beispielsweise ein Schwingquarz - auf, die ein Referenzsignal sref erzeugt. Weiterhin weist die Oszillatorvorrichtung 555 einen Frequenzteiler 557 zur Erzeugung eines Rechtecksignals als erstes Oszillatorsignal ZF'(fs) und einen Konverter 558 zur Erzeugung eines an eine Sinus- oder Kosinusform angenäherte Signalform als zweites Oszillatorsignal ZF(fs) auf.

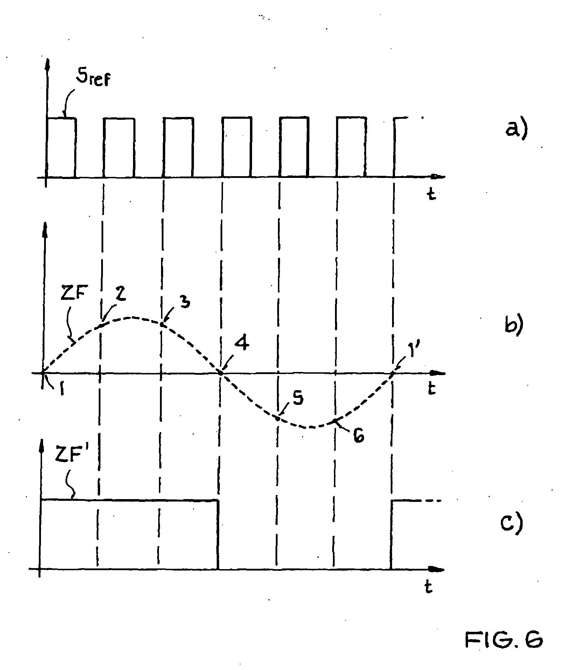

Beispiele für das erste Oszillatorsignal ZF'(fs) und das zweite Oszillatorsignal ZF(fs) sind in der Fig. 6 als schematisches Diagramm gezeigt. Das Referenzsignal sref, das erste Oszillatorsignal ZF'(fs) und das zweite Oszillatorsignal ZF(fs) sind dabei über der Zeit t aufgetragen. Das Referenzsignal sref ist beispielsweise ein digitales Taktsignal, das eine Rechteckform aufweist. Das erste Oszillatorsignal ZF'(fs) ist zum Referenzsignal sref synchronisiert und weist zu jedem Zeitpunkt einer steigenden Flanke des Referenzsignals sref einen Stützwert 1, 2, 3, 4, 5, 6, 1' auf, wobei die Position des Stützwertes einer Sinusform - in Fig. 6 gestichelt angedeutet - angenähert ist. Das zweite Oszillatorsignal ZF(fs) ist durch Teilung 1: 6 aus dem Referenzsignal gewonnen. Steigende und fallende Flanken des zweiten Oszillatorsignals ZF(fs) fallen dabei mit den Nulldurchgängen des ersten Oszillatorsignals ZF'(fs) zusammen, so dass beide Signale die gleiche Frequenz aufweisen und zueinander phasenstarr sind. Im Ausführungsbeispiel der Fig. 6 sind beide Phasenlagen des ersten Oszillatorsignals ZF'(fs) und des zweiten Oszillatorsignals ZF(fs) sogar identisch.

Die Erfindung ist dabei nicht auf die Ausführungsbeispiele der Figuren 1 bis 6 beschränkt. So kann der Fachmann das Wandlerkonzept einfach auf weitere Sensortypen, Analog-Digital-Wandlertypen und andere Gleichspannungs-Signale anderer Quellen übertragen.

### Bezugszeichenliste

- 101: analoger Frequenzumsetzer
- 103: Analog/Digital-Wandler
- 105: digitaler Frequenzumsetzer
- 150: Steuereinrichtung
- 155: Oszillatorvorrichtung
- 201: Signalgenerator
- 203: analoger Frequenzumsetzer
- 205: Analog/Digftal-Wandier
- 207: digitaler Frequenzumsetzer
- 209: analoges Filter
- 250: Steuereinrichtung
- 255: Oszillatorvorrichtung
- 301: Transistor
- 303: Transistor
- 305: Stromquelle
- 307: Transistor
- 309: Stromquelle
- 310: Operationsverstärker
- 311: Kapazität
- 313: Kapazität
- 315: Detektor
- 317: digitaler Frequenzumsetzer
- 319: digitaler Frequenzumsetzer
- 350: Steuereinrichtung
- 355: Oszillatorvorrichtung
- 401: Signalgenerator
- 402: Signalgenerator
- 403: analoger Frequenzumsetzer
- 404: analoger Frequenzumsetzer
- 405: Analog/Digital-Wandler
- 407: Filter, Dezimationsfilter
- 409: digitaler Frequenzumsetzer
- 411: digitaler Frequenzumsetzer
- 412: Filter
- 413: Filter
- 415: Demodulator
- 421: Auswerteeinrichtung
- 422: Auswerteeinrichtung
- 450: Steuereinrichtung
- 455: Oszillatorvorrichtung
- 501: analoger Mischer
- 503: analoger Mischer
- 505: Filter
- 507: Schalter
- 509: Mischer
- 511: Signalgenerator
- 512: Analog/Digital-Wandler
- 513: digitaler Mischer
- 514: Demodulator
- 515: Filter
- 516: Filter
- 517: Mikrocontroller
- 519: Demodulator
- 520: Auswerteeinrichtung
- 521: PLL-Schaltung
- 523: Leistungsverstärker
- 550: Steuereinrichtung
- 555: Oszillatorvorrichtung
- 556: Referenzelement
- 557: Frequenzteiler
- 558: Signalkonverter
- Rx data: Empfangsdaten
- S_{A}, s_{A1}, s_{A2}: analoges Gleichspannungs-Signal
- s_{D}, s_{D1}, s_{D2}: digitales Signal
- sw, e₁, e₂: Steuersignal
- sref: Referenzsignal
- t: Zeit
- ZF'(f_{S}), ZF'_{Q}(f_{S}), ZF'_{I}(f_{S}): erste Oszillatorsignal
- ZF(f_{S}), ZF_{Q}(f_{S}), ZF_{I}(f_{S}): zweites Oszillatorsignal

## Patentansprüche

**1.** Wandlervorrichtung zum Wandeln eines analogen Signals (s_{A}) in ein digitales Signal (s_{D}),
- mit einer Oszillatorvorrichtung (155) zur Ausgabe eines ersten Oszillatorsignals (ZF'(f_{S})) und eines zweiten Oszillatorsignals (ZF(f_{S})), wobei die Oszillatorvorrichtung (155) ausgebildet ist das erste Oszillatorsignal (ZF'(f_{S})) und das zweite Oszillatorsignal (ZF(f_{S})) zueinander phasenstarr und mit gleicher Frequenz (f_{S}) aus einem Referenzsignal (sref) zu erzeugen,
- mit einem mit der Oszillatorvorrichtung (155) verbundenen analogen Frequenzumsetzer (101) zum Umsetzen des analogen Signals (s_{A}) mittels des ersten Oszillatorsignals (ZF'(f_{S})) in einen ersten Spektralbereich mit einer ersten Mittenfrequenz, um ein umgesetztes Signal zu erhalten,
- mit einem Analog/Digital-Wandler (103) zum Wandeln des umgesetzten Signals in ein umgesetztes digitales Signal; und
- mit einem mit der Oszillatorvorrichtung (155) verbundenen digitalen Frequenzumsetzer (105) zum Umsetzen des umgesetzten digitalen Signals mittels des zweiten Oszillatorsignals (ZF(f_{S})) in einen zweiten Spektralbereich mit einer zweiten Mittenfrequenz, um das digitale Signal (s_{D}) zu erhalten,
- mit einem Schalter (507) zum Schalten eines Ausgangs des analogen Frequenzumsetzers (101) auf einen Eingang des Analog/Digital-Wandlers (103),
- bei der der Schalter (507) ausgebildet ist, in einer ersten Schalterstellung den Ausgang des analogen Frequenzumsetzers (101) auf den Eingang des Analog/Digital-Wandlers (103) und in einer zweiten Schalterstellung einen weiteren Anschluss auf den Eingang des Analog/Digital-Wandlers (103) zu schalten,
- bei der an den weiteren Anschluss ein Sendesignal oder ein Empfangssignal anlegbar ist,
- mit einer Anzahl von mit dem digitalen Frequenzumsetzer (101) verschalteten digitalen Filtern (515, 516)
**dadurch gekennzeichnet, dass** das anologe signal (s_{A}) ein Gleichspannungs-Signal ist, wobei die Wandervorrichtung ferner
- eine Steuereinrichtung (550) aufweist, die zur von der ersten Schalterstellung beziehungsweise der zweiten Schalterstellung abhängigen Einstellung von Eckfrequenzen des jeweiligen Filters (515, 516) eingerichtet ist.

**2.** Wandlervorrichtung gemäß Anspruch 1, bei der das Referenzsignal eine höhere Frequenz als das erste und zweite Oszillatorsignal - insbesondere ein ganzzahliges Vielfaches der Frequenz des ersten und zweiten Oszillatorsignals - aufweist.

**3.** Wandlervorrichtung gemäß Anspruch 1 oder 2, bei der Signalwerte des zweiten Oszillatorsignals innerhalb einer Periode des zweiten Oszillatorsignals genähert eine Sinus- oder Kosinusform abbilden.

**4.** Wandlervorrichtung gemäß einem der Ansprüche 1 bis 3, mit einer Anzahl von mit dem digitalen Frequenzumsetzer zur Ausbildung einer Filterung eines analogen 1/f-Rauschens verschalteten digitalen Filtern.

**5.** Wandlervorrichtung gemäß einem der Ansprüche 1 bis 4, wobei der digitale Frequenzumsetzer (105) ein Basisbandmischer ist.

**7.** Wandlervorrichtung gemäß einem der Ansprüche 1 bis 6, bei der dem Analog/Digital-Wandler ein Dezimationsfilter nachgeschaltet ist.

**8.** Wandlervorrichtung gemäß einem der Ansprüche 1 bis 7, bei der dem digitalen Frequenzumsetzer (105) ein Tiefpassfilter nachgeschaltet ist.

**9.** Wandlervorrichtung gemäß einem der Ansprüche 1 bis 8,
- bei der der digitale Frequenzumsetzer einen ersten Mischer zum Anlegen eines In-Phase-Anteils des zweiten Oszillatorsignals und einen zweiten Mischer zum Anlegen eines Quadratur-Phase-Anteils des zweiten Oszillatorsignal aufweist,
- bei der der analoge Frequenzumsetzer einen ersten Mischer zum Anlegen eines ersten Signalanteils des ersten Oszillatorsignals mit gleicher Phasenlage wie der In-Phase-Anteil des zweiten Oszillatorsignals und einen zweiten Mischer zum Anlegen eines zweiten Signalanteils mit gleicher Phasenlage wie der Quadratur-Phase-Anteil des zweiten Oszillatorsignals aufweist.

**10.** Empfangsvorrichtung mit der Wandlervorrichtung gemäß einem der Ansprüche 1 bis 9, wobei ein Empfangssignal an einen Eingang des Analog/Digital-Wandlers anlegbar ist.

**11.** Verfahren zum Wandeln eines analogen Signals in ein digitales Signal,
- bei dem mittels einer Oszillatorvorrichtung ein erstes Oszillatorsignal und ein zweites Oszillatorsignal aus einem Referenzsignal erzeugt werden, wobei das erste Oszillatorsignal und das zweite Oszillatorsignal zueinander phasenstarr sind und eine gleiche Frequenz aufweisen,
- bei dem das analoge Signal mittels eines mit der Oszillatorvorrichtung verbundenen analogen Frequenzumsetzers in Abhängigkeit vom ersten Oszillatorsignal in einen ersten Spektralbereich mit einer ersten Mittenfrequenz umgesetzt wird, um ein umgesetztes Signal zu erhalten
- bei dem das umgesetzte Signal mittels eines Analog/DigitalWandlers in ein umgesetztes digitales Signal gewandelt wird, und
- bei dem das umgesetzte digitale Signal mittels eines mit der Oszillatorvorrichtung verbundenen digitalen Frequenzumsetzers in Abhängigkeit vom zweiten Oszillatorsignal in einen zweiten Spektralbereich mit einer zweiten Mittenfrequenz umgesetzt wird, um das digitale Signal zu erhalten,
- bei dem in einer ersten Schalterstellung eines Schalters ein Ausgang des analogen Frequenzumsetzers auf einen Eingang des Analog/Digital-Wandlers und in einer zweiten Schalterstellung des Schalters ein weiterer Anschluss auf den Eingang des Analog/DigitalWandlers geschaltet wird,
**dadurch gekennzeichnet, dass** das analoge Signal (s_{A}) ein Gleichspannungsignal ist, wobei
- bei dem von der ersten Schalterstellung beziehungsweise der zweiten Schalterstellung abhängig Eckfrequenzen eines mit dem digitalen Frequenzumsetzer verschalteten digitalen Filters eingestellt werden.

## Claims

**1.** Converter device for converting an analog signal (s_{A}) into a digital signal (s_{D}),
- with an oscillator device (155) for output of a first oscillator signal (ZF'(f_{S})) and a second oscillator signal (ZF(f_{S})), wherein the oscillator device (155) is constructed to generate the first oscillator signal (ZF'(f_{S})) and the second oscillator signal (ZF(f_{S})) in fixed phase relative to one another and with the same frequency (f_{S}) from a reference signal (sref),
- with an analog frequency translator (101), which is connected with the oscillator device (155), for translation of the analog signal (s_{A}) by means of the first oscillator signal (ZF'(f_{S})) into a first spectral range with a first centre frequency in order to obtain a translated signal
- with an analog/digital converter (103) for converting the translated signal into a translated digital signal; and
- with a digital frequency translator (105) which is connected with the oscillator device (155), for translating the translated digital signal by means of the second oscillator signal (ZF'(f_{S})) into a second spectral range with a second centre frequency in order to obtain the digital signal (s_{D}),
- with a switch (507) for switching an output of the analog frequency translator (101) to an input of the analog/digital converter (103),
- in which the switch (507) is constructed to switch the output of the analog frequency translator (101) to the input of the analog/digital converter (103) in a first switch setting and to switch a further connection to the input of the analog/digital converter (103) in a second switch setting,
- in which a transmitted signal or a received signal can be applied to the further connection,
- with a number of digital filters (515, 516) connected with the digital frequency translator (101),
**characterised in that** the analog signal (s_{A}) is a direct voltage signal, wherein the converter device further comprises a control device (550) which is arranged for the setting of cut-off frequencies of the respective filter (515, 516) in dependence on the first switch setting or the second switch setting.

**2.** Converter device according to claim 1, in which the reference signal has a higher frequency than the first and second oscillator signal, particularly an integral number multiple of the frequency of the first and second oscillator signal.

**3.** Converter device according to claim 1 or 2, in which the signal values of the second oscillator signal approximately duplicate a sine or cosine form within a period of the second oscillator signal.

**4.** Converter device according to any one of claims 1 to 3, with a number of digital filters connected with the digital frequency translator for formation of a filtering of an analog 1/f noise.

**5.** Converter device according to any one of claims 1 to 4, wherein the frequency translator (105) is a baseband mixer.

**7.** Converter device according to any one of claims 2 to 6, in which a decimation filter is connected downstream of the analog/digital converter.

**8.** Converter device according to any one of claims 1 to 7, in which a low-pass filter is connected downstream of the digital frequency translator (105).

**9.** Converter device according to any one of claims 1 to 8,
- in which the digital frequency translator comprises a first mixer for application of an in-phase component of the second oscillator signal and a second mixer for application of a quadrature phase component of the second oscillator signal and
- in which the analog frequency translator comprises a first mixer for application of a first signal component of the first oscillator signal with the same phase position as the in-phase component of the second oscillator signal and a second mixer for application of a second signal component with the same phase position as the quadrature phase component of the second oscillator signal.

**10.** Receiving device with the converter device according to any one of claims 1 to 9, wherein a received signal can be applied to an input of the analog/digital converter.

**11.** Method of converting an analog signal into a digital signal,
- in which a first oscillator signal and a second oscillator signal are generated from a reference signal by means of an oscillator device, wherein the first oscillator signal and the second oscillator signal are in fixed phase relative to one another and have the same frequency,
- in which the analog signal is translated by means of an analog frequency translator, which is connected with the oscillator device, in dependence on the first oscillator signal into a first spectral range with a first centre frequency in order to obtain a translated signal,
- in which the translated signal is converted by means of an analog/digital converter into a translated digital signal and
- in which the translated digital signal is translated by means of a digital frequency translator, which is connected with the oscillator device, in dependence on the second oscillator signal into a second spectral range with a second centre frequency in order to obtain the digital signal,
- in which an output of the analog frequency translator is connected to an input of the analog/digital converter in a first switch setting and a further connection is connected to the input of the analog/digital converter in a second switch setting, **characterised in that** the analog signal (s_{A}) is a direct voltage signal, wherein cut-off frequencies of a digital filter connected with the digital frequency translator are set in dependence on the first switch setting or the second switch setting.

## Revendications

**1.** Dispositif convertisseur pour la conversion d'un signal analogique (S_{A}) en un signal numérique (S_{D}) comprenant :
. un oscillateur (155) pour la délivrance d'un premier signal d'oscillateur (ZF'(fs)) et d'un deuxième signal d'oscillateur (ZF (fs)) selon lequel le dispositif d'oscillateur (155) est configuré de façon que le premier signal d'oscillateur (ZF'(fs)) et le deuxième signal d'oscillateur (ZF(fs)) soient verrouillés en phase et de la même fréquence à partir d'un signal de référence (sref),
. un convertisseur analogique de fréquences (101) relié à l'oscillateur (155) pour convertir le signal analogique (S_{A}) par l'intermédiaire du premier signal d'oscillateur (ZF'(fs)) dans une première bande spectrale comportant une première fréquence centrale pour la mémorisation d'un signal de conversion,
· un convertisseur analogique/numérique (103) pour la conversion du signal converti en un signal numérique converti,
. un convertisseur numérique de fréquences (105) relié à l'oscillateur (155) pour la conversion du signal numérique converti par l'intermédiaire du deuxième signal d'oscillateur (ZF(fs)) dans une deuxième bande spectrale comportant une deuxième fréquence centrale pour la mémorisation du signal numérique,
. un commutateur (507) pour commuter une sortie du convertisseur analogique de fréquences (101) sur une entrée du convertisseur analogique/numérique (103),
selon lequel le commutateur (507) est configuré pour que dans une première position, la sortie du convertisseur analogique de fréquences (101) se commute sur l'entrée du convertisseur analogique/numérique (103) et pour que dans une deuxième position, une autre connexion se commute sur l'entrée du convertisseur analogique/numérique (103),
selon lequel un signal d'émission ou un signal de réception peut être appliqué sur l'autre connexion,
comprenant une pluralité de filtres numériques (515,516) interconnectés au convertisseur numérique de fréquences (101)
**caractérisé en ce que** le signal analogique (S_{A}) est un signal de tension continue, **en ce que** le dispositif convertisseur présente en outre une unité de commande (505) pour l'établissement du réglage des fréquences de coupure de chaque filtre (515, 516) qui dépendent du premier état, respectivement du deuxième état de commutation.

**2.** Dispositif convertisseur selon la revendication 1 **caractérisé en ce que** le signal de référence présente une fréquence supérieure au premier et au deuxième signal d'oscillateur en particulier un multiple entier de la fréquence du premier et du deuxième signal d'oscillateur.

**3.** Dispositif convertisseur selon la revendication 1 ou 2 **caractérisé en ce que** la valeur du signal du deuxième signal d'oscillateur à l'intérieur d'une période du deuxième signal d'oscillateur présente une forme proche de celle d'une sinusoïde ou d'une cosinusoïde.

**4.** Dispositif convertisseur selon l'une des revendications 1 à 3 **caractérisé par** un nombre de filtres numériques interconnectés au convertisseur numérique de fréquences pour la définition d'un filtrage de 1/f bruit analogique.

**5.** Dispositif convertisseur selon l'une des revendications 1 à 4 **caractérisé en ce que** le convertisseur de fréquences (105) est un mélangeur dans la bande de base.

**7.** Dispositif convertisseur selon l'une des revendications 1 à 6 **caractérisé en ce que** le convertisseur analogique/numérique est un filtre à décimation.

**8.** Dispositif convertisseur selon l'une des revendications 1 à 7 **caractérisé en ce que** le convertisseur numérique de fréquences (105) est un filtre passe bas.

**9.** Dispositif convertisseur selon l'une des revendications 1 à 8 **caractérisé en ce que** le convertisseur numérique de fréquences comporte un premier mélangeur pour appliquer une fraction en phase du deuxième signal d'oscillateur et un deuxième mélangeur pour appliquer une fraction en quadrature de phase du deuxième signal d'oscillateur
et **en ce que**
le convertisseur analogique de fréquences comporte un premier mélangeur pour l'application d'une première fraction de signal du premier signal d'oscillateur avec la même phase que la fraction en phase du deuxième signal d'oscillateur et comporte un deuxième mélangeur pour appliquer une deuxième fraction de signal avec la même phase que la fraction en quadrature de phase du deuxième signal d'oscillateur.

**10.** Dispositif de réception comportant le dispositif convertisseur selon l'une des revendications 1 à 9 dans lequel un signal de réception peut être appliqué à une entrée du convertisseur analogique/numérique.

**11.** Procédé pour convertir un signal analogique en un signal numérique dans lequel :
· on génère par un dispositif oscillateur un premier et un deuxième signal d'oscillateur à partir d'un signal de référence, le premier signal d'oscillateur et le deuxième signal d'oscillateur étant verrouillé en phase et de même fréquence,
. le signal analogique est converti dans une première bande spectrale présentant une première fréquence centrale par l'intermédiaire d'un convertisseur analogique de fréquences relié au dispositif oscillateur en fonction d'un premier signal d'oscillateur en vue de mémoriser un signal converti,
. le signal converti est converti en un signal numérique converti par un convertisseur analogique/numérique et
. le signal numérique converti est converti dans une deuxième bande spectrale présentant une deuxième fréquence centrale par l'intermédiaire d'un convertisseur numérique de fréquences relié au dispositif oscillateur en fonction d'un deuxième signal d'oscillateur en vue de mémoriser le signal numérique,
. dans une première position d'un commutateur on commute une sortie du convertisseur analogique de fréquences sur une entrée du convertisseur analogique/numérique et dans une deuxième position du commutateur on commute une autre connexion sur l'entrée du convertisseur analogique/numérique,
**caractérisé en ce que** le signal analogique (S_{A}) est un signal de tension continue et on effectue le réglage des fréquences de coupure d'un filtre numérique interconnecté avec le convertisseur numérique dépendant du premier, respectivement du deuxième état de commutation.
